(19) Europäisches Patentamt / European Patent Office / Office européen des brevets

(11) **EP 2 788 831 B1**

(12) **FASCICULE DE BREVET EUROPEEN**

(45) Date de publication et mention de la délivrance du brevet:
**09.01.2019 Bulletin 2019/02**

(51) Int Cl.:
*G05F 1/67* *(2006.01)*  *H02H 3/08* *(2006.01)*
*H02H 7/20* *(2006.01)*  *G01R 31/40* *(2014.01)*
*H01L 31/02* *(2006.01)*  *H02H 1/00* *(2006.01)*
*H02S 50/10* *(2014.01)*

(21) Numéro de dépôt: **12795484.0**

(22) Date de dépôt: **06.12.2012**

(86) Numéro de dépôt international:
**PCT/EP2012/074696**

(87) Numéro de publication internationale:
**WO 2013/083723 (13.06.2013 Gazette 2013/24)**

(54) **PROCEDE ET DISPOSITIF DE DETECTION D'ARC ELECTRIQUE DANS UNE INSTALLATION PHOTOVOLTAIQUE**

VERFAHREN UND VORRICHTUNG ZUR ERKENNUNG VON LICHTBÖGEN IN EINER PHOTOVOLTAIKANLAGE

METHOD AND DEVICE FOR DETECTING ELECTRIC ARC IN A PHOTOVOLTAIC INSTALLATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.12.2011 FR 1161388**

(43) Date de publication de la demande:
**15.10.2014 Bulletin 2014/42**

(73) Titulaire: **COMMISSARIAT À L'ÉNERGIE ATOMIQUE ET AUX ÉNERGIES ALTERNATIVES**
**75015 Paris (FR)**

(72) Inventeurs:
• **GOUY-PAILLER, Cédric**
**F-78000 Versailles (FR)**
• **CHAINTREUIL, Nicolas**
**F-73800 Montmelian (FR)**

(74) Mandataire: **Novaimo**
**ActiTech 8**
**60 avenue Marie Curie**
**Archamps Technopole**
**74166 Saint Julien-en-Genevois Cedex (FR)**

(56) Documents cités:
WO-A1-98/27476    WO-A1-2011/058433
US-B1- 6 892 178    US-B1- 7 366 622

• SCHIMPF F ET AL: "Recognition of electric arcing in the DC-wiring of photovoltaic systems", TELECOMMUNICATIONS ENERGY CONFERENCE, 2009. INTELEC 2009. 31ST INTERNATIONAL, IEEE, PISCATAWAY, NJ, USA, 18 octobre 2009 (2009-10-18), pages 1-6, XP031579534, ISBN: 978-1-4244-2490-0
• KUSË LJEVICÂ' M D ET AL: "Active power measurement algorithm for power system signals under non-sinusoidal conditions and wide-range frequency deviations", IET GENERATION, TRANSMISSION & DISTRIBUTION,, vol. 3, no. 1, 12 janvier 2009 (2009-01-12), pages 57-65, XP006032305, ISSN: 1751-8695, DOI: 10.1049/IET-GTD:20080158

**Description**

L'invention concerne un procédé de détection d'un arc électrique dans un système photovoltaïque. Elle concerne aussi un dispositif de sécurité détectant l'apparition d'arcs électriques, et un module photovoltaïque et un système photovoltaïque équipés d'un tel dispositif de sécurité détectant l'apparition d'arcs électriques.

Les installations photovoltaïques fonctionnent à tension continue et courant continu importants, ce qui engendre des risques d'apparition d'arcs électriques. De tels arcs électriques peuvent survenir suite à une erreur de manipulation, par exemple si un opérateur ouvre malencontreusement un connecteur en charge, ou suite à la dégradation des connexions de l'installation. Ces arcs électriques génèrent une forte chaleur de plasma pendant une durée importante puisque sous tension continue, la valeur de la tension n'est jamais nulle au contraire d'un système alternatif, et sont de ce fait très dangereux pour les personnes et les installations. De plus, l'intégration des modules photovoltaïques dans la toiture des bâtiments risque de déclencher l'incendie des charpentes en cas d'arc électrique.

Les installations photovoltaïques peuvent être reliées au réseau électrique par l'intermédiaire d'un onduleur. Dans une telle configuration, il existe des systèmes de sécurité permettant de détecter un éventuel arc électrique survenant sur la liaison électrique entre un champ de modules photovoltaïques et l'onduleur. Toutefois, ces systèmes sont insuffisants puisqu'un tel arc électrique est susceptible de se produire au niveau d'un module photovoltaïque lui-même. Il n'existe aucune solution de sécurité contre un tel risque.

Le document WO2010072717 de l'état de la technique propose la détection d'un arc électrique dans une installation photovoltaïque sur la base de l'analyse d'une onde ultrasonore et la reconnaissance de la signature ultrasonore d'un arc électrique dans cette onde. Pour cela, cette solution analyse en continu les signatures ultrasonores. Il en résulte une méthode nécessitant un calcul complexe et un dispositif coûteux. Voir aussi 'Recognition of Electric Arcing in the DC-Wiring of Photovoltaic Systems'; F. Schimpf, L. Norum, 31st Télécommunications Energy Conférence, IEEE 2009.

Le document FR2912848 décrit une méthode simplifiée de détection d'un arc électrique à partir de la simple mesure de tension et de la détection de son augmentation rapide. Toutefois, cette méthode est insuffisante pour faire la distinction entre un arc électrique et différents événements distincts qui induisent aussi une augmentation de tension.

Ainsi, un objet général de l'invention est de proposer une solution de détection d'un arc électrique dans une installation photovoltaïque, simple, peu coûteuse et fiable, afin d'améliorer la sécurité de telles installations.

A cet effet, l'invention repose sur un procédé de détection d'un arc électrique dans une installation photovoltaïque, caractérisé en ce qu'il comprend les étapes suivantes :

- Mesure de valeurs de tension en au moins un endroit du circuit électrique de l'installation photovoltaïque ;
- Numérisation des valeurs de tension mesurées pour former un échantillonnage de données x ;
- Calcul d'une valeur d'estimation y de présence d'un arc électrique à partir d'un calcul statistique sur l'échantillonnage de données et de la prise en compte d'un facteur d'oubli $\Phi$ ;
- Comparaison de la valeur d'estimation y de présence d'un arc électrique avec une valeur seuil pour en déduire la présence ou non d'un arc électrique au sein de l'installation photovoltaïque.

Le calcul statistique peut être basé sur la variance ou l'écart-type.

Le facteur d'oubli peut être combiné avec chaque donnée d'échantillonnage x pour permettre de définir un poids de plus en plus faible aux données de l'échantillonnage à chaque itération, pour prendre en compte l'historique des valeurs mesurées et prendre en compte indirectement la durée d'une éventuelle période de chaos.

Le facteur d'oubli peut dépendre d'une fréquence d'échantillonnage.

Le facteur d'oubli peut être constant et choisi en respectant les règles définies par le tableau suivant :

| Fréquence d'échantillonnage $F_{ech}$ | Facteur d'oubli $\Phi$ compris dans l'intervalle |
|---|---|
| 50 - 300 kHz inclus | [0.965 ; 0.975] |
| 301 - 750 kHz inclus | [0.975 ; 0.985] |
| 751 KHz - 8 Mhz inclus | [0.985 ; 0.995] |

Le calcul d'une valeur d'estimation de présence d'un arc électrique peut mettre en oeuvre les calculs suivants, répétés pour chaque donnée numérisée x:

- d'abord, on recalcule trois variables a, b, et c de la manière suivante, à partir des valeurs précédentes de ces variables a, b et c :

$$a \leftarrow \Phi\, a + x^2$$

$$b \leftarrow \Phi\, b + x$$

$$c \leftarrow \Phi\, c + 1$$

- ensuite, la valeur d'estimation y de présence d'arc électrique est calculée par la formule suivante :
-

$$y = \frac{a - b^2/c}{c - 5}$$

Le procédé de détection d'un arc électrique dans une installation photovoltaïque peut comprendre une phase d'initialisation du traitement lors de l'allumage du dispositif de sécurité, qui comprend les étapes suivantes :

- initialisation des variables a, b, c à zéro et du facteur d'oubli ;
- itération des calculs suivants sur un nombre prédéfini de données x :

$$a \leftarrow \Phi\, a + x^2$$

$$b \leftarrow \Phi\, b + x$$

$$c \leftarrow \Phi\, c + 1$$

- puis initialisation du seuil de détection d'arc électrique par la formule suivante :

$$\text{seuil} = k\,.\,\frac{a - b^2/c}{c - 5}$$

où k est un paramètre compris entre 5 et 200.

Si l'étape de comparaison de la valeur d'estimation y de présence d'un arc électrique avec une valeur seuil vérifie y > seuil, alors il peut être estimé qu'il existe un arc électrique au sein de l'installation photovoltaïque, puis le procédé peut comprendre une étape consistant à intervenir sur le circuit électrique de l'installation photovoltaïque en cas de détection d'un arc électrique, afin d'éteindre l'arc électrique.

L'invention porte aussi sur un dispositif de sécurité pour une installation photovoltaïque, comprenant un ou plusieurs capteur(s) de mesure de tension, relié(s) par une liaison de communication à une unité de traitement, comprenant un convertisseur analogique numérique pour numériser les mesures reçues par le ou les capteur(s) de mesure de tension, caractérisé en ce que l'unité de traitement met en oeuvre le procédé de détection d'un arc électrique dans l'installation photovoltaïque tel que décrit précédemment.

L'unité de traitement peut être reliée par un moyen de communication à un dispositif d'intervention dont la fonction est d'interrompre l'arc électrique, pour supprimer tout risque.

L'invention porte aussi sur une installation photovoltaïque, caractérisée en ce qu'elle comprend au moins un dispositif de sécurité tel que décrit ci-dessus.

Ces objets, caractéristiques et avantages de la présente invention seront exposés en détail dans la description suivante d'un mode d'exécution particulier fait à titre non-limitatif en relation avec les figures jointes parmi lesquelles :

La figure 1 illustre schématiquement une installation photovoltaïque.

La figure 2 représente un exemple d'évolution de la tension au sein d'une installation photovoltaïque en fonction du temps en présence d'un arc électrique.

La figure 3 illustre schématiquement un dispositif de sécurité associé à une installation photovoltaïque selon un mode d'exécution de l'invention.

La figure 4 illustre quelques étapes du procédé de détection d'arc électrique au sein d'une installation photovoltaïque selon un mode d'exécution de l'invention.

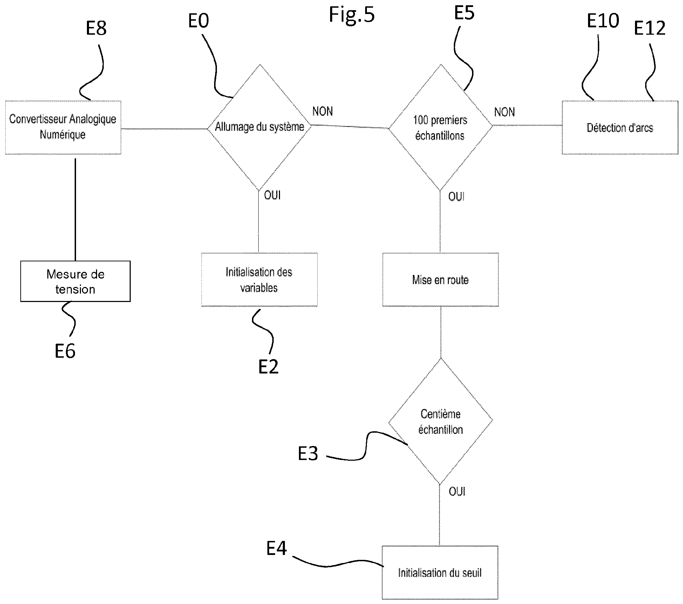

La figure 5 illustre plus globalement le procédé de détection d'arc électrique au sein d'une installation photovoltaïque selon un mode d'exécution de l'invention.

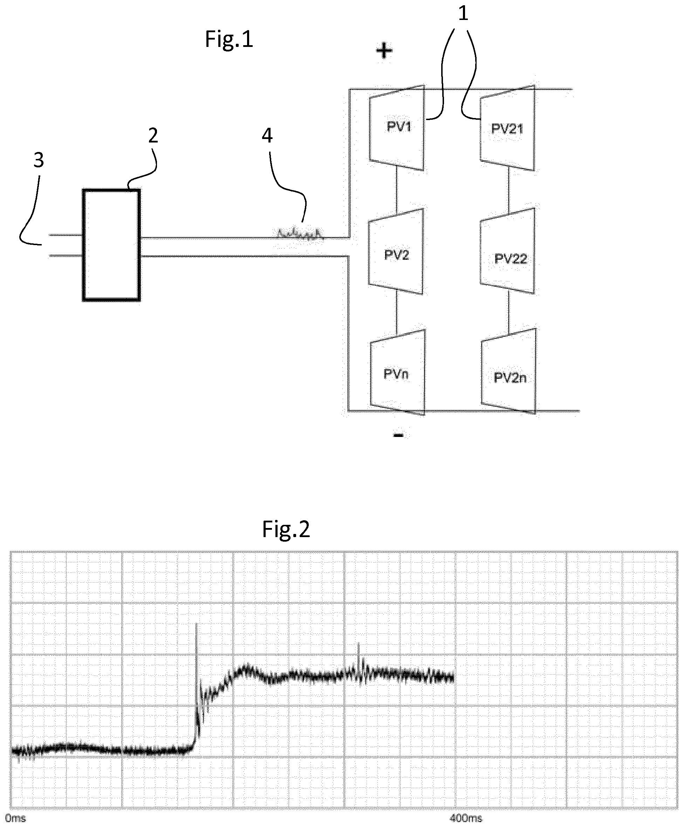

L'invention repose sur la seule mesure de la tension au sein d'une installation photovoltaïque. Cette dernière, représentée schématiquement sur la figure 1, comprend plusieurs modules photovoltaïques 1 (PVi) reliés à un onduleur 2 qui convertit le courant continu produit par les modules photovoltaïques 1 en un courant alternatif, pour une liaison sur un réseau électrique 3 standard, non représenté.

A partir d'une mesure de tension, l'invention cherche à déduire la présence ou non d'un arc électrique 4, qui peut se trouver au niveau d'un ou plusieurs module(s) photovoltaïque(s) 1, entre ces modules et un onduleur 2, ou à tout endroit sur le circuit électrique de l'installation photovoltaïque. Un arc électrique provoque une augmentation importante de la tension au sein de l'installation photovoltaïque, et peut prendre une forme telle qu'illustrée en figure 2 selon un exemple. L'augmentation du signal de tension peut apparaître en même temps que l'arc, et durer de quelques millisecondes à quelques heures. Plus généralement, l'amplitude du signal obtenu dépend de la position du détecteur et d'autres paramètres. Cette augmentation de la tension s'accompagne toujours d'une augmentation subite de l'énergie du signal, d'un chaos dans le signal.

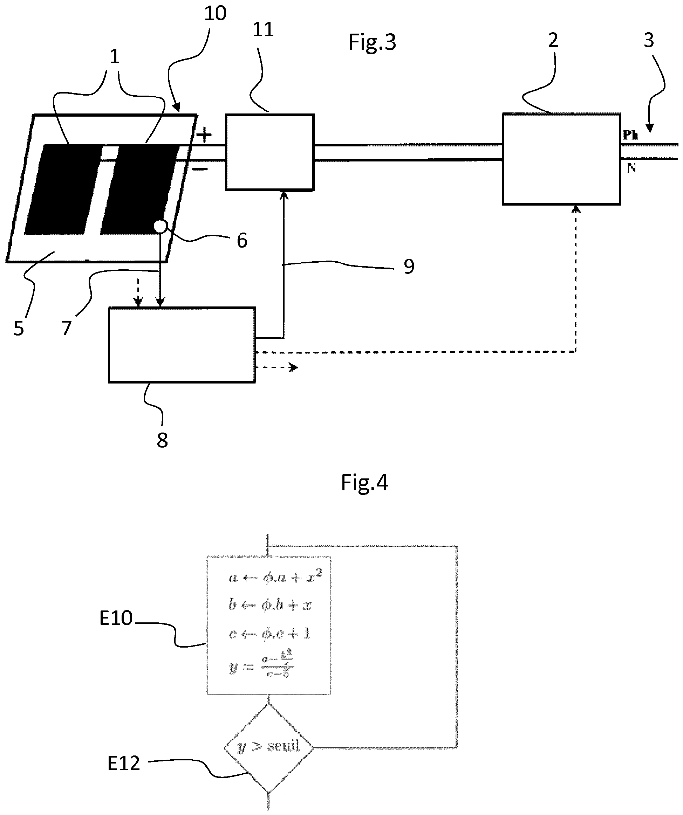

La figure 3 représente schématiquement un dispositif de sécurité pour une installation photovoltaïque 10 telle que décrite sur la figure 1, qui comprend deux modules photovoltaïques 1 à titre d'exemple simplifié montés sur un châssis 5, qui sont reliés au réseau électrique traditionnel 3 par l'intermédiaire d'un onduleur 2. Le dispositif de sécurité comprend un ou plusieurs capteur(s) de mesure de tension 6, positionné(s) par exemple au niveau d'un module photovoltaïque 1 et/ou à tout autre endroit du circuit électrique de l'installation photovoltaïque. Ce (ou ces) capteur de mesure de tension 6 est relié par une liaison de communication 7 à une unité de traitement 8 apte à analyser les données transmises par le(s) capteur(s) de mesure de tension 6. Cette unité de traitement 8 est elle-même reliée par un moyen de communication 9 à un dispositif d'intervention 11 dont la fonction est d'interrompre l'arc électrique sur demande de l'unité de traitement 8 en cas d'arc électrique, pour supprimer tout risque électrique et toute future détérioration.

L'unité de traitement 8 comprend un convertisseur analogique numérique, pour numériser les données reçues provenant du ou des capteur(s) de mesure de tension. Elle a pour fonction d'analyser les données reçues par le(s) capteur(s) de mesure de tension 6 et met en oeuvre un procédé de détection d'arcs électriques, qui sera détaillé ci-dessous. Pour cela, elle peut comprendre une unité de calcul, comme un microcontrôleur, et des moyens de mémorisation, ou plus généralement tout composant matériel (hardware) et/ou logiciel (software). En remarque, comme les données à traiter sont numérisées, il est possible d'utiliser un ou plusieurs microcontrôleurs déjà existant(s) au sein d'une installation photovoltaïque pour mettre en oeuvre le procédé de détection d'arc électrique qui sera détaillé ci-dessous, sans ajout d'un composant additionnel. La solution est donc peu coûteuse.

Enfin, le dispositif de sécurité 10 peut être soit disposé sur une des bornes à la sortie de l'installation photovoltaïque, soit se trouver sur chaque module photovoltaïque, par exemple dans sa boîte de raccordement. Toute solution intermédiaire est naturellement envisageable.

Le procédé de détection d'arc électrique selon l'invention va maintenant être détaillé.

Il comprend une étape d'échantillonnage de valeurs de tension. Pour cela, différentes valeurs de tension sont mesurées au cours du temps, lors d'une étape de mesure E6, et numérisées, lors d'une étape de numérisation E8, par le convertisseur numérique de l'unité de traitement, selon une fréquence d'échantillonnage $F_{ech}$ choisie. Ensuite, ces valeurs sont traitées pour en déduire une détection d'apparition ou non d'un arc électrique.

Selon ce mode de réalisation, ce traitement exploite la constatation que la quantité de chaos présente dans le signal augmente significativement pendant l'apparition d'un arc électrique. Ainsi, le principe retenu consiste à définir une valeur d'estimation de présence d'un arc électrique liée à la variance des valeurs obtenues lors de l'échantillonnage.

Ensuite, selon ce mode de réalisation, un paramètre, appelé « facteur d'oubli », qui dépend de la fréquence d'échantillonnage $F_{ech}$, est utilisé pour prendre en compte l'historique, proche dans le temps, des valeurs de tension mesurées, et tenir compte ainsi indirectement de la durée d'une éventuelle période de chaos. Ce facteur d'oubli permet ainsi par exemple de s'affranchir d'un filtre numérique passe-bande, qui est toujours utilisé dans l'état de la technique pour éliminer certains bruits qui ne sont pas liés à un arc électrique, notamment ceux créés par les signaux de communication qui transitent de l'installation vers l'unité de traitement, et qui présentent notamment la particularité d'être de plus courte durée. D'autre part, le facteur d'oubli, notamment par sa dépendance de la fréquence d'échantillonnage, permet d'optimiser le lien entre la fréquence d'échantillonnage et le traitement effectué, en évitant les adaptations complexes obligatoires entre les filtres passe-bande et la fréquence d'échantillonnage des solutions de l'état de la technique.

Selon le mode de réalisation choisi, pour chaque échantillon de valeurs de tension mesurées et converties par le convertisseur numérique pour fournir des données x, les calculs suivants sont mis en oeuvre :

d'abord, on définit les trois variables a, b, et c de la manière suivante :

$$a \leftarrow \Phi\, a + x^2$$

$$b \leftarrow \Phi\, b + x$$

$$c \leftarrow \Phi\, c + 1$$

où $\Phi$ est le facteur d'oubli, qui est constant et initialisé en fonction de la fréquence d'échantillonnage choisie. A titre d'exemple, le facteur d'oubli peut être défini selon la valeur de la fréquence d'échantillonnage $F_{ech}$ en respectant les règles selon le tableau suivant :

| Fréquence d'échantillonnage $F_{ech}$ | Facteur d'oubli $\Phi$ compris dans l'intervalle |
|---|---|
| 50 - 300 kHz inclus | [0.965 ; 0.975] |
| 301 - 750 kHz inclus | [0.975 ; 0.985] |
| 751 KHz - 8 Mhz | [0.985 ; 0.995] |

En variante, ce facteur d'oubli peut ne pas dépendre de la fréquence d'échantillonnage, être par exemple une constante inférieure à 1.

Enfin, la variable y, qui représente une valeur d'estimation de présence d'arc électrique, à partir de la variance des valeurs échantillonnées modifiées par la prise en compte du facteur d'oubli $\Phi$, est calculée de la manière suivante :

$$y = \frac{a - b^2/c}{c - 5}$$

Ces calculs des trois variables a, b, c et de la valeur d'estimation y de présence d'arc électrique sont calculées dans une étape de calcul E10 qui est répétée pour chaque nouvelle donnée x de l'échantillonnage.

Finalement, le procédé de détection d'arc électrique comprend une étape de comparaison E12 de cette valeur d'estimation y avec une valeur seuil, pour en déduire ou non la présence d'un arc électrique. Si y > seuil, alors le procédé considère qu'il y a présence d'un arc électrique et induit la mise en sécurité de l'installation photovoltaïque, par l'intermédiaire du dispositif d'intervention 11. Pour cela, un ordre d'interruption du fonctionnement du système photovoltaïque peut permettre de stopper l'arc électrique, en supprimant ainsi le risque que représenterait l'entretien de l'arc électrique, notamment le risque d'incendie.

L'itération précédente, schématiquement représentée par la figure 4, permet donc d'ajouter un poids inférieur à une donnée plus ancienne qu'une autre, pour tenir compte de l'historique des données obtenues et de leur répartition dans le temps. Tout autre calcul permettant de fixer un poids de plus en plus faible pour chaque donnée obtenue à chaque itération peut permettre d'atteindre en variante un résultat exploitable pour former des variantes de réalisation.

Le procédé de détection d'arc électrique comprend une étape préliminaire d'initialisation, qui fixe la valeur de seuil en prenant en compte les premières valeurs de tension mesurées à l'allumage E0 du dispositif de sécurité.

A l'instant initial, les variables a, b, c sont initialisées à 0, dans une étape d'initialisation E2, puis calculées selon les formules explicitées ci-dessus. Le facteur d'oubli est de même initialisé en fonction des règles prédéfinies, telles qu'explicitées ci-dessus à titre d'exemple. Ensuite, les calculs tels que présentés à l'étape E10 sont répétés selon un nombre d'itérations prédéfini, par exemple 100 itérations pour prendre en compte 100 échantillons de mesures de tension. Pour cela, le procédé comprend une étape de test E5 de l'atteinte de ce nombre prédéfini d'échantillons d'allumage, pour savoir si le procédé se trouve dans une phase d'initialisation ou dans une phase de fonctionnement normal, mettant en oeuvre les étapes E10, E12 explicitées précédemment. Dans le cadre d'une phase d'initialisation, le procédé met en oeuvre une étape de test de fin d'allumage E3. Lorsque cette fin d'allumage est atteinte, c'est à dire que le nombre prédéfini d'itérations d'allumage est atteint, les variables a, b, c résultantes sont utilisées pour définir une valeur seuil de la manière suivante, à l'étape d'initialisation de la valeur seuil E4 :

$$\text{seuil} = k \cdot \frac{a - b^2/c}{c - 5}$$

où k est un paramètre, choisi entre 5 et 200, selon un compromis choisi entre deux extrêmes : si k est au plus bas, tous les arcs électriques sont détectés, mais il existe un risque de fausse alerte. Si k est plus haut, le risque de fausse détection est réduit mais on augmente le risque de ne pas détecter un arc électrique.

Le traitement mis en oeuvre repose sur une estimation d'apparition d'arc électrique à partir de la variance d'un échantillonnage de mesures de tension numérisées et modifiées pour incorporer un facteur d'oubli. La variance représente une bonne méthode statistique pour évaluer le chaos de l'échantillonnage : naturellement, tout autre calcul différent de ceux présentés ci-dessus à titre d'exemple peut être mis en oeuvre, comme tout calcul lié à la variance ou toute autre dimension statistique équivalente, comme l'écart type par exemple, et plus généralement tout calcul statistique basé sur toute formule statistique, utilisant uniquement les valeurs de l'échantillonnage ou leur carré.

Le procédé décrit précédemment permet d'utiliser un indicateur analogue à la variance statistique, c'est-à-dire considérant les différents moments d'ordre 2 des données de l'échantillonnage, mais obtenu de manière plus stable et plus simple grâce à l'introduction des trois variables a, b, c mentionnées. Le procédé recalcule la valeur des trois variables a, b, c à chaque pas de temps en tenant compte de l'historique de ces variables a, b, c, du carré de la valeur mesurée $x^2$ (valeur numérisée de la tension mesurée) et de la valeur mesurée x elle-même.

De plus, le concept de l'invention ne se limite pas aux dispositifs photovoltaïques décrits ci-dessus mais peut être mis en oeuvre dans toute sorte d'installation photovoltaïque, avec de nombreux modules photovoltaïques.

La solution retenue permet donc bien de répondre aux objets recherchés et présente les avantages suivants :

- comme le traitement repose sur la seule mesure de la tension, le procédé est simple ;
- ensuite, comme le procédé met en oeuvre une numérisation pour procéder à un seul calcul statistique, il est très simple et ne nécessite pas une puissance de calcul importante ;
- enfin, le dispositif est simplifié au maximum et donc peu coûteux, puisqu'il ne nécessite pas de filtre, du fait du calcul qui prend en compte un facteur d'oubli. En variante, il reste compatible avec l'utilisation additionnelle et optionnelle d'un filtre ;
- cette solution est bien sûr compatible et complémentaire avec d'autres solutions de détection d'arc électrique, et peut donc être combinée avec ces autres solutions.

## Revendications

**1.** Procédé de détection d'un arc électrique dans une installation photovoltaïque, **caractérisé en ce qu'**il comprend les étapes suivantes :

- Mesure (E6) de valeurs de tension en au moins un endroit du circuit électrique de l'installation photovoltaïque ;
- Numérisation (E8) des valeurs de tension mesurées pour former un échantillonnage de données x ;
- Calcul (E10) d'une valeur d'estimation y de présence d'un arc électrique à partir d'un calcul statistique sur l'échantillonnage de données et de la prise en compte d'un facteur d'oubli Φ ;
- Comparaison (E12) de la valeur d'estimation y de présence d'un arc électrique avec une valeur seuil pour en déduire la présence ou non d'un arc électrique au sein de l'installation photovoltaïque.

**2.** Procédé de détection d'un arc électrique dans une installation photovoltaïque selon la revendication précédente, **caractérisé en ce que** l'étape de calcul (E10) d'une valeur d'estimation y de présence d'un arc électrique comprend le calcul de trois variables a, b, c à chaque élaboration d'une nouvelle donnée d'échantillonnage x, en tenant compte de l'historique de ces variables a, b, c, comme leur valeur au pas de temps précédent, du carré de la nouvelle donnée d'échantillonnage $x^2$ et de la nouvelle donnée d'échantillonnage x elle-même.

**3.** Procédé de détection d'un arc électrique dans une installation photovoltaïque selon la revendication 1 ou 2, **caractérisé en ce que** le calcul statistique est basé sur la variance ou l'écart-type ou une valeur analogue à la variance ou l'écart-type.

6

4. Procédé de détection d'un arc électrique dans une installation photovoltaïque selon l'une des revendications précédentes, **caractérisé en ce que** le facteur d'oubli est combiné avec chaque donnée d'échantillonnage x pour permettre de définir un poids de plus en plus faible aux données de l'échantillonnage à chaque itération, pour prendre en compte l'historique des valeurs mesurées et prendre en compte indirectement la durée d'une éventuelle période de chaos.

5. Procédé de détection d'un arc électrique dans une installation photovoltaïque selon l'une des revendications précédentes, **caractérisé en ce que** le facteur d'oubli dépend d'une fréquence d'échantillonnage.

6. Procédé de détection d'un arc électrique dans une installation photovoltaïque selon la revendication précédente, **caractérisé en ce que** le facteur d'oubli est constant et choisi en respectant les règles définies par le tableau suivant :

| Fréquence d'échantillonnage $F_{ech}$ | Facteur d'oubli $\Phi$ compris dans l'intervalle |
|---|---|
| 50 - 300 kHz inclus | [0.965 ; 0.975] |
| 301 - 750 kHz inclus | [0.975 ; 0.985] |
| 751 KHz - 8 Mhz inclus | [0.985 ; 0.995] |

7. Procédé de détection d'un arc électrique dans une installation photovoltaïque selon l'une des revendications précédentes, **caractérisé en ce que** le calcul d'une valeur d'estimation de présence d'un arc électrique met en oeuvre les calculs suivants, répétés pour chaque donnée numérisée x:

   - d'abord, on recalcule trois variables a, b, et c de la manière suivante, à partir des valeurs précédentes de ces variables a, b et c :

$$a \leftarrow \Phi\, a + x^2$$

$$b \leftarrow \Phi\, b + x$$

$$c \leftarrow \Phi\, c + 1$$

   - ensuite, la valeur d'estimation y de présence d'arc électrique est calculée par la formule suivante :

   -

$$y = \frac{a - b^2/c}{c - 5}$$

8. Procédé de détection d'un arc électrique dans une installation photovoltaïque selon la revendication précédente, **caractérisé en ce qu'**il comprend une phase d'initialisation du traitement lors de l'allumage (E0) du dispositif de sécurité, qui comprend les étapes suivantes :

   - initialisation (E2) des variables a, b, c à zéro et du facteur d'oubli ;
   - itération des calculs suivants sur un nombre prédéfini de données x :

$$a \leftarrow \Phi\, a + x^2$$

$$b \leftarrow \Phi\, b + x$$

$$c \leftarrow \Phi\, c + 1$$

- puis initialisation du seuil (E4) de détection d'arc électrique par la formule suivante :

$$\text{seuil}= k \cdot \frac{a - b^2/c}{c - 5}$$

où k est un paramètre compris entre 5 et 200.

9. Procédé de détection d'un arc électrique dans une installation photovoltaïque selon l'une des revendications précédentes, **caractérisé en ce que** si l'étape de comparaison (E12) de la valeur d'estimation y de présence d'un arc électrique avec une valeur seuil vérifie y > seuil, alors il est estimé qu'il existe un arc électrique au sein de l'installation photovoltaïque, puis **en ce qu'**il comprend une étape consistant à intervenir sur le circuit électrique de l'installation photovoltaïque en cas de détection d'un arc électrique, afin d'éteindre l'arc électrique.

10. Dispositif de sécurité pour une installation photovoltaïque, comprenant un ou plusieurs capteur(s) de mesure de tension (6), relié(s) par une liaison de communication (7) à une unité de traitement (8), comprenant un convertisseur analogique numérique pour numériser les mesures reçues par le ou les capteur(s) de mesure de tension, **caractérisé en ce que** l'unité de traitement (8) est configurée pour mettre en oeuvre le procédé de détection d'un arc électrique dans l'installation photovoltaïque selon l'une des revendications précédentes.

11. Dispositif de sécurité pour une installation photovoltaïque selon la revendication précédente, **caractérisé en ce que** l'unité de traitement (8) est reliée par un moyen de communication (9) à un dispositif d'intervention (11) dont la fonction est d'interrompre l'arc électrique, pour supprimer tout risque.

12. Installation photovoltaïque, **caractérisée en ce qu'**elle comprend au moins un dispositif de sécurité selon la revendication 10 ou 11.

**Patentansprüche**

1. Verfahren zur Erkennung eines Lichtbogens in einer Photovoltaikanlage, **dadurch gekennzeichnet, dass** es die folgenden Schritte umfasst:

   - Messen (E6) von Spannungswerten an mindestens einer Stelle des elektrischen Schaltkreises der Photovoltaikanlage;
   - Digitalisieren (E8) der gemessenen Spannungswerte, um ein Datensampling x zu bilden;
   - Berechnen (E10) eines Schätzwerts y des Vorhandenseins eines Lichtbogens aus einer statistischen Berechnung am Datensampling und aus der Berücksichtigung eines Vergessensfaktors $\Phi$;
   - Vergleichen (E12) des Schätzwerts y des Vorhandenseins eines Lichtbogens mit einem Grenzwert, um davon das Vorhandensein oder nicht eines Lichtbogens in der Photovoltaikanlage abzuleiten.

2. Verfahren zur Erkennung eines Lichtbogens in einer Photovoltaikanlage nach dem vorhergehenden Anspruch, **dadurch gekennzeichnet, dass** der Schritt des Berechnens (E10) eines Schätzwerts y des Vorhandenseins eines Lichtbogens das Berechnen von drei Variablen a, b, c bei jeder Ausarbeitung eines neuen Samplingdatums x unter Berücksichtigung der Historie dieser Variablen a, b, c als ihr Wert zum vorhergehenden Zeitabschnitt, des Quadrats des neuen Samplingdatums $x^2$ und des neuen Samplingdatums x selbst umfasst.

3. Verfahren zur Erkennung eines Lichtbogens in einer Photovoltaikanlage nach Anspruch 1 oder 2, **dadurch gekennzeichnet, dass** die statistische Berechnung auf der Varianz oder der typischen Abweichung oder einem Wert analog zur Varianz oder typischen Abweichung basiert.

4. Verfahren zur Erkennung eines Lichtbogens in einer Photovoltaikanlage nach einem der vorhergehenden Ansprüche, **dadurch gekennzeichnet, dass** der Vergessensfaktor mit jedem Samplingdatum x kombiniert wird, um es zu ermöglichen, ein immer geringeres Gewicht für die Samplingdaten bei jeder Iteration zu definieren, um die Historie der gemessenen Werte zu berücksichtigen und indirekt die Dauer einer eventuellen Chaosperiode zu berücksichtigen.

**5.** Verfahren zur Erkennung eines Lichtbogens in einer Photovoltaikanlage nach einem der vorhergehenden Ansprüche, **dadurch gekennzeichnet, dass** der Vergessensfaktor von einer Samplingfrequenz abhängt.

**6.** Verfahren zur Erkennung eines Lichtbogens in einer Photovoltaikanlage nach dem vorhergehenden Anspruch, **dadurch gekennzeichnet, dass** der Vergessensfaktor kontant ist und unter Einhaltung der durch folgende Tabelle definierten Regeln ausgewählt wird:

| Samplingfrequenz $F_{ech}$ | Vergessensfaktor $\Phi$ in dem Intervall |
|---|---|
| 50-300 kHz inklusive | [0,965; 0,975] |
| 301-750 kHz inklusive | [0,975; 0,985] |
| 751 kHz - 8 MHz inklusive | [0,985; 0,995] |

**7.** Verfahren zur Erkennung eines Lichtbogens in einer Photovoltaikanlage nach einem der vorhergehenden Ansprüche, **dadurch gekennzeichnet, dass** die Berechnung eines Schätzwerts des Vorhandenseins eines Lichtbogens die folgenden Berechnungen einsetzt, die für jedes digitalisierte Datum x wiederholt werden:

- erstens werden drei Variablen a, b, c auf folgende Weise aus den vorhergehenden Werten dieser Variablen a, b und c neu berechnet:

$$a \leftarrow \Phi a + x^2$$

$$b \leftarrow \Phi b + x$$

$$c \leftarrow \Phi c + 1$$

- dann wird der Schätzwert des Vorhandenseins eines Lichtbogens durch folgende Formel berechnet:

$$y = \frac{a - b^2/c}{c - 5}$$

**8.** Verfahren zur Erkennung eines Lichtbogens in einer Photovoltaikanlage nach dem vorhergehenden Anspruch, **dadurch gekennzeichnet, dass** es eine Phase der Initialisierung der Verarbeitung beim Einschalten (E0) der Sicherheitsvorrichtung umfasst, umfassend die folgenden Schritte:

- Initialisierung (E2) der Variablen a, b, c auf Null und des Vergessensfaktors;
- Iteration der folgenden Berechnungen an einer vordefinierten Anzahl von Daten x:

$$a \leftarrow \Phi a + x^2$$

$$b \leftarrow \Phi b + x$$

$$c \leftarrow \Phi c + 1$$

- dann Initialisierung der Lichtbogenerkennungsgrenze (E4) durch folgende Formel:

$$\text{Grenze} = k. \frac{a-b^2/c}{c-5}$$

wobei k ein Parameter zwischen 5 und 200 ist.

9. Verfahren zur Erkennung eines Lichtbogens in einer Photovoltaikanlage nach einem der vorhergehenden Ansprüche, **dadurch gekennzeichnet, dass**, wenn der Schritt des Vergleichens (E12) des Schätzwerts y des Vorhandenseins eines Lichtbogens mit einem Grenzwert y > Grenze überprüft, geschätzt wird, dass ein Lichtbogen innerhalb der Photovoltaikanlage vorhanden ist, dann dass es einen Schritt umfasst, der darin besteht, in den elektrischen Schaltkreis der Photovoltaikanlage im Falle des Erkennens eines Lichtbogens einzugreifen, um den Lichtbogen zu löschen.

10. Sicherheitsvorrichtung für eine Photovoltaikanlage, umfassend einen oder mehrere Spannungsmessfühler (6), der(die) durch eine Kommunikationsverbindung (7) mit einer Verarbeitungseinheit (8) verbunden ist(sind), umfassend einen Analog-Digital-Wandler, um die von dem oder den Spannungsmessfühler(n) empfangenen Messungen zu digitalisieren, **dadurch gekennzeichnet, dass** die Verarbeitungseinheit (8) eingerichtet ist, um das Verfahren zur Erkennung eines Lichtbogens in der Photovoltaikanlage nach einem der vorhergehenden Ansprüche einzusetzen.

11. Sicherheitsvorrichtung für eine Photovoltaikanlage nach dem vorhergehenden Anspruch, **dadurch gekennzeichnet, dass** die Verarbeitungseinheit (8) durch ein Kommunikationsmittel (9) mit einer Interventionsvorrichtung (11) verbunden ist, deren Funktion darin besteht, den Lichtbogen zu unterbrechen, um jede Gefahr zu unterbinden.

12. Photovoltaikanlage, **dadurch gekennzeichnet, dass** sie mindestens eine Sicherheitsvorrichtung nach Anspruch 10 oder 11 umfasst.

**Claims**

1. Method for detecting an electrical arc in a photovoltaic installation, **characterized in that** it comprises the following steps:

   - measurement (E6) of voltage values at at least one point of the electrical circuit of the photovoltaic installation;
   - digitization (E8) of the measured voltage values to form a sampling of data x;
   - calculation (E10) of an estimation value y of the presence of an electrical arc based on a statistical calculation on the sampling of data and the inclusion of an omission factor $\Phi$;
   - comparison (E12) of the estimation value y of the presence of an electrical arc with a threshold value to deduce therefrom the presence or absence of an electrical arc in the photovoltaic installation.

2. Method for detecting an electrical arc in a photovoltaic installation according to claim the preceding claim, **characterized in that** the step of calculation (E10) of an estimation value y of the presence of an electrical arc comprises the calculation of three variables a, b, c each time a new sampling datum x is generated, by taking into account the history of these variables a, b, c, like their value at the preceding time step, the square of the new sampling datum $x^2$ and the new sampling datum x itself.

3. Method for detecting an electrical arc in a photovoltaic installation according to Claim 1 or 2, **characterized in that** the statistical calculation is based on the variance or standard deviation or a value similar to the variance or standard deviation.

4. Method for detecting an electrical arc in a photovoltaic installation according to one of the preceding claims, **characterized in that** the omission factor is combined with each sampling datum x to make it possible to define an increasingly low weight for the sampling data on each iteration, to take account of the history of the measured values and indirectly take account of the duration of a potential period of chaos.

5. Method for detecting an electrical arc in a photovoltaic installation according to one of the preceding claims, **characterized in that** the omission factor depends on a sampling frequency.

6. Method for detecting an electrical arc in a photovoltaic installation according to the preceding claim, **characterized in that** the omission factor is constant and chosen by observing the rules defined by the following table:

| Sampling frequency $F_{ech}$ | Omission factor $\Phi$ contained within the range |
|---|---|
| 50 - 300 kHz inclusive | [0.965; 0.975] |
| 301 - 750 kHz inclusive | [0.975; 0.985] |
| 751 kHz - 8 MHz inclusive | [0.985; 0.995] |

7. Method for detecting an electrical arc in a photovoltaic installation according to one of the preceding claims, **characterized in that** the calculation of an estimation value of the presence of an electrical arc implements the following calculations, repeated for each digitized datum x:

   - first of all, three variables a, b and c are recalculated as follows, based on the preceding values of these variables a, b and c:

   $$a \leftarrow \Phi\, a + x^2$$

   $$b \leftarrow \Phi\, b + x$$

   $$c \leftarrow \Phi\, c + 1$$

   - then, the estimation value y of the presence of an electrical arc is calculated by the following formula:

   $$y = \frac{a - b^2/c}{c - 5}$$

8. Method for detecting an electrical arc in a photovoltaic installation according to the preceding claim, **characterized in that** it comprises a processing initialization phase upon the switching-on (E0) of the safety device, which comprises the following steps:

   - initialization (E2) of the variables a, b, c at zero and of the omission factor;
   - iteration of the following calculations on a predefined number of data x:

   $$a \leftarrow \Phi\, a + x^2$$

   $$b \leftarrow \Phi\, b + x$$

   $$c \leftarrow \Phi\, c + 1$$

   - then initialization of the electrical arc detection threshold (E4) by the following formula:

   $$\text{threshold} = k\,.\frac{a - b^2/c}{c - 5}$$

where k is a parameter between 5 and 200.

9. Method for detecting an electrical arc in a photovoltaic installation according to one of the preceding claims, **characterized in that** if the step of comparison (E12) of the estimation value y of the presence of an electrical arc with a threshold value satisfies y > threshold, then it is estimated that there is an electrical arc in the photovoltaic installation, then in that it comprises a step consisting in intervening on the electrical circuit of the photovoltaic installation in the event of the detection of an electrical arc, in order to extinguish the electrical arc.

10. Safety device for a photovoltaic installation, comprising one or more voltage measurement sensor(s) (6), linked by a communication link (7) to a processing unit (8), comprising an analogue-digital converter for digitizing the measurements received by the voltage measurement sensor(s), **characterized in that** the processing unit (8) is configured to implement the method for detecting an electrical arc in the photovoltaic installation according to one of the preceding claims.

11. Safety device for a photovoltaic installation according to the preceding claim, **characterized in that** the processing unit (8) is linked by a communication means (9) to an intervention device (11), the function of which is to stop the electrical arc, to eliminate any risk.

12. Photovoltaic installation, **characterized in that** it comprises at least one safety device according to Claim 10 or 11.

Fig.1

Fig.2

Fig.3

Fig.4

$$a \leftarrow \phi.a + x^2$$
$$b \leftarrow \phi.b + x$$
$$c \leftarrow \phi.c + 1$$
$$y = \frac{a - \frac{b^2}{c}}{c - 5}$$

E10

$y > \text{seuil}$

E12

EP 2 788 831 B1

## Fig.5

E8

E0

E5

E10  E12

Convertisseur Analogique
Numérique

Allumage du système — NON — 100 premiers échantillons — NON — Détection d'arcs

OUI

OUI

Mesure de
tension

Initialisation des
variables

Mise en route

E6

E2

Centième
échantillon

E3

OUI

E4

Initialisation du seuil

15

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2010072717 A

- FR 2912848

**Littérature non-brevet citée dans la description**

- Recognition of Electric Arcing in the DC-Wiring of Photovoltaic Systems. **F. SCHIMPF ; L. NORUM.** 31st Télécommunications Energy Conférence. IEEE, 2009